**Europäisches Patentamt**

**European Patent Office**

**Office européen des brevets**

(19)

(11) Veröffentlichungsnummer: **0 288 016 B1**

(12)

# EUROPÄISCHE PATENTSCHRIFT

(45) Veröffentlichungstag der Patentschrift: **30.03.94**

(51) Int. Cl.⁵: **G01R 19/00**, G01R 19/165,
H03K 5/24

(21) Anmeldenummer: **88106238.4**

(22) Anmeldetag: **19.04.88**

(54) **Komparator mit erweitertem Eingangsgleichtaktspannungsbereich.**

(30) Priorität: **21.04.87 DE 3713376**

(43) Veröffentlichungstag der Anmeldung:
**26.10.88 Patentblatt 88/43**

(45) Bekanntmachung des Hinweises auf die
Patenterteilung:
**30.03.94 Patentblatt 94/13**

(84) Benannte Vertragsstaaten:
**DE FR GB IT SE**

(56) Entgegenhaltungen:
**EP-A- 0 134 925**
**US-A- 4 300 063**

**IEEE JOURNAL OF SOLID-STATE CIRCUITS.
vol. 20, no. 6, Dezember 1985, NEW YORK US
Seiten 1149 - 1150; J.H.Huijsing et.al.: "Low-
voltage operational amplifier with rail-to-rail
input and output ranges"**

(73) Patentinhaber: **SGS-THOMSON MICROELEC-
TRONICS GMBH
Haidling 17
D-85567 Grafing(DE)**

(72) Erfinder: **Hrassky, Petr, Dr.
Brunhuberstrasse 43
D-8090 Wasserburg(DE)**

(74) Vertreter: **Klunker . Schmitt-Nilson . Hirsch
Winzererstrasse 106
D-80797 München (DE)**

## Beschreibung

Die Erfindung betrifft einen Komparator gemäß Oberbegriff des Patentanspruchs 1.

Komparatoren dienen zum Vergleich zweier Eingangsspannungen. Das heißt, sie bewerten die zwischen ihrem invertierenden und ihrem nicht-invertierenden Eingang anliegende Differenzspannung. Dies können sie jedoch nicht bei beliebigen Eingangsgleichtakt-Spannungen. Dies deshalb, weil der Komparator nur dann in der gewünschten Weise funktioniert, wenn er in seinem linearen Bereich arbeitet. Bei üblichen Komparatoren liegt der zulässige Eingangsgleichtaktspannungsbereich zwischen der Versorgungsspannung und Masse und ist kleiner als die vorhandene Versorgungsspannung.

In vielen Anwendungsfällen reicht dieser zulässige Anwendungsbereich der Eingangsgleichtakt-Spannung nicht aus. Wenn beispielsweise die Versorgungsspannung der Versorgungsspannungsquelle nur 1,5 V beträgt, wie dies z.B. bei elektrischen Armbanduhren der Fall ist, bleiben nur noch etwa 0,5 V für den nutzbaren Bereich der Eingangsgleichtakt-Spannung.

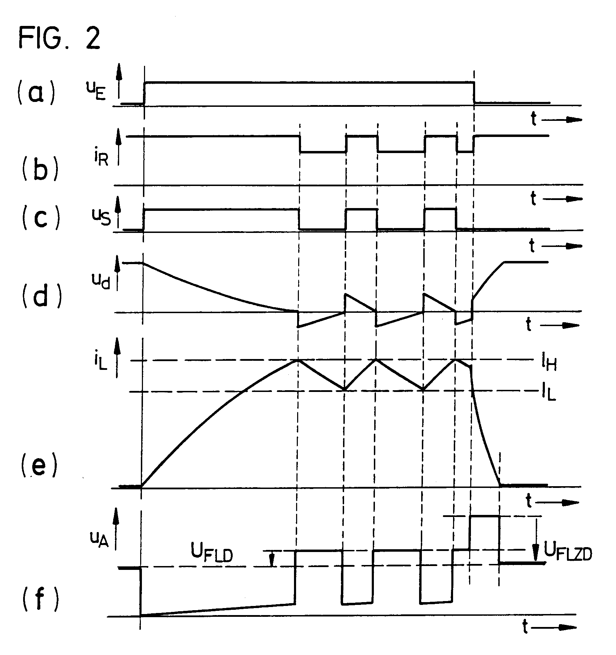

Ein Komparator der eingangs angegebenen Art ist in Fig. 2 der Veröffentlichung "Low-Voltage Operational Amplifier with Rail-to-Rail Input and Output Ranges" von Johan H. Huijsing, erschienen im IEEE Journal of Solid-State Circuits, Vol. SC-20, Nr. 6, Dezember 1985, S. 1144 bis 1150, gezeigt. Durch die Verwendung zweier parallelge-schalteter Eingangs-Differenzstufen, von denen eine ein npn-Transistorpaar in Emitterschaltung und die andere ein pnp-Transistorpaar in Emitterschaltung aufweist, und durch die Verwendung einer gemeinsamen Konstantstromquelle, deren Strom mit Hilfe einer Stromumleitschaltung im unteren Bereich der Eingangsgleichtakt-Spannung zu der einen Eingangs-Differenzstufe, im oberen Bereich der Eingangsgleichtakt-Spannung zu der anderen Eingangs-Differenzstufe und in einem mittleren Übergangsbereich zu beiden Eingangs-Differenzstufen geleitet wird, und durch die Verwendung eines gemeinsamen Stromspiegels, der mittels einer weiteren Spannungsquelle vorgespannt und beiden Endes mittels Widerständen mit der einen bzw. der anderen Eingangs-Differenzstufe gekoppelt ist, erreicht man, daß die zulässige Eingangsgleichtakt-Spannung etwa 0,2 V unterhalb und oberhalb des Versorgungsspannungsbereichs liegen kann.

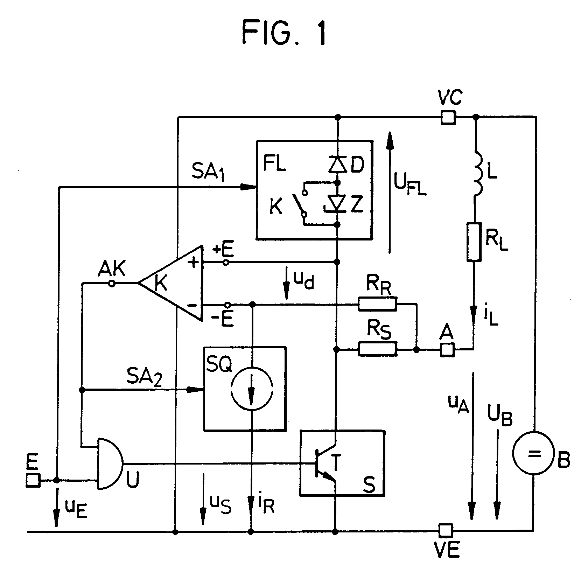

Es gibt jedoch Anwendungsfälle, die einen Komparator erforderlich machen, der auch noch bei Eingangsgleichtakt-Spannungen funktionieren muß, die weit über die Versorgungsspannung hinausgehen oder weit unter dem Massepotential liegen. Ein Beispiel eines solchen Anwendungsfalls ist ein geschalteter Stromregler für eine induktive Last, wie er in Fig. 1 hinsichtlich seines Schaltungsaufbaus und in den Fig. 2a bis 2f hinsichtlich einiger Spannungs- und Strom-Verläufe gezeigt ist. Die genaue Funktionsweise dieses Stromreglers ist in der gleichzeitig eingereichten deutschen Patentanmeldung P 37 13 377 der Anmelderin mit dem Titel "geschalteter Stromregler" beschrieben, so daß vorliegend eine kurze Erläuterung ausreicht.

Solange ein Transistor T eingeschaltet ist, fließt ein Laststrom $i_L$ durch die induktive Last mit der Induktivität L und dem Lastwiderstand $R_L$ und durch einen Sensorwiderstand $R_S$. Wird der Transistor T ausgeschaltet, fließt der Laststrom $i_L$ durch eine Freilaufschaltung FL mit einer Diode D und einer Zenerdiode Z. Dieser Freilaufstrom kann allerdings erst fließen, wenn die infolge des Ausschaltvorgangs in der Induktivität L induzierte negative Spannung die Freilaufspannung $U_{FL}$ der Freilaufschaltung FL erreicht, weil dann erst die Dioden D und Z leiten. Während der Freilaufphase ist daher die Ausgangsspannung $u_A$ am Ausgang A gleich der Summe aus der Versorgungsspannung $U_B$ und der Freilaufspannung $U_{FL}$.

Während der Stromregelung wird die Zenerdiode Z mit Hilfe eines Schalters K überbrückt, so daß für die Freilaufspannung nur die relativ niedrige Durchlaßspannung der Diode D wirkt, so daß man einen langsamen Stromabfall in der Freilaufphase erreicht. Um nach dem Abschalten des Stromreglers einen raschen Abfall des Laststroms auf Null zu erreichen, öffnet man den Schalter K, so daß dann als Freilaufspannung die Summe aus Zenerspannung und Diodendurchlaßspannung wirksam wird. Während dieser Freilaufsphase steigt die Ausgangsspannung $u_A$ am Ausgang A des Stromreglers auf Werte an, die weit über der Versorgungsspannung liegen. Wird der Stromregler beispielsweise als Solenoid- oder Magnetventil-Treiber in Kraftfahrzeugen benutzt, werden für ein schnelles Abschalten des Stromreglers Zenerdioden verwendet, die zu einer Freilaufspannung im Bereich von 20 V führen. Bei einer Anwendung im Kraftfahrzeugbereich wird eine Betriebsspannung von bis zu 24 V gefordert. Somit kommt man in der Abschalt-Freilaufphase auf eine Ausgangsspannung $u_A$ im Bereich von 44 V.

Diese sehr weit über der Versorgungsspannung $U_B$ liegende Spannung muß ein Komparator K als Eingangsgleichtakt-Spannung verarbeiten können, der die Sensorspannung über $R_S$ mit der Referenzspannung über $R_R$ vergleicht und den Transistor T in Abhängigkeit von dem Vergleichsergebnis ein- oder ausschaltet.

Eine Komparatorschaltung der aus der oben angegebenen Druckschrift bekannten Art ist weit davon entfernt, mit einer derartigen Eingangsgleichtakt-Spannung fertigzuwerden.

Der Erfindung liegt die Aufgabe zugrunde, einen Komparator der eingangs angegebenen Art derart zu verbessern, daß er Eingangsgleichtakt-Spannungen verarbeiten kann, die weit über seiner Versorgungsspannung liegen.

Eine Lösung dieser Aufgabe ist im Anspruch 1 angegeben und kann den Unteransprüchen gemäß vorteilhaft weitergebildet werden.

Dadurch, daß erfindungsgemäß mindestens eine der beiden Eingangs-Differenzstufen ein Transistorpaar in Basisschaltung aufweist, deren Emitteranschlüsse je mit einem der beiden Komparatoreingänge verbunden sind, wird ein Komparator geschaffen, dessen Eingangsgleichtakt-Spannung über den Spannungswert mindestens des einen Pols der Versorgungsspannungsquelle weit hinausgehen kann. Dabei wirkt die Eingangsgleichtakt-Spannung als Versorgungsspannung für die Basisschaltungs-Eingangs-Differenzstufe. Die Eingangsgleichtakt-Spannung ist daher nur durch die herstellungstechnologiebedingte Durchbruchspannung beschränkt.

Durch die Stromumleitung zu der einen oder der anderen Eingangs-Differenzstufe werden diese so aktiviert, daß linearer Betrieb innerhalb des gesamten Eingangsgleichtakt-Spannungsbereichs sichergestellt wird.

In bevorzugter Weise sind zwischen die Basisanschlüsse der zu dem Transistorpaar der anderen Eingangs-Differenzstufe gehörenden Transistoren und die beiden Komparatoreingänge je ein Pegelverschiebungs-Emitterfolger geschaltet. Damit erreicht man, daß die Eingangsgleichtakt-Spannung über den Spannungswert des anderen Pols der Versorgungsspannungsquelle etwas hinausgehen kann, bei der Verwendung von bipolaren Siliziumtransistoren um etwa 0,4 V.

Bei Parallelschaltung einer Eingangs-Differenzstufe in Emitterschaltung mit einer Eingangs-Differenzstufe in Basisschaltung kann somit die zulässige Eingangsgleichtakt-Spannung die an den Versorgungsspannungsanschlüssen anliegende Versorgungsspannung einen Endes etwas und anderen Endes weit übersteigen.

Für Anwendungsfälle, die erfordern, daß die Eingangsgleichtakt-Spannung die Versorgungsspannung beiden Endes weit überschreiten kann, kann man zwei Eingangs-Differenzstufen parallel schalten, die je ein Transistorpaar in Basisschaltung aufweisen.

Der Einsatz des erfindungsgemäßen Komparators ist nicht auf die Verwendung in einem geschalteten Stromregler für induktive Last beschränkt. Er ist in allen Fällen einsetzbar, in welchen aus irgendwelchen Gründen eine Eingangsgleichtakt-Spannung zulässig sein muß, die weit über die Versorgungsspannung hinausgehen kann. Die erfindungsgemäße Schaltung eignet sich auch für einen linearen Operationsverstärker, der bei einer weit über seine Versorgungsspannung hinausreichenden Eingangsgleichtakt-Spannung arbeiten können muß.

Die erfindungsgemäße Schaltung kann auch mit CMOS- oder einer kombinierten Bipolar-CMOS-Technologie realisiert werden.

Eine Differenzstufe in Basisschaltung zu betreiben, ist an sich bekannt aus Patents Abstracts of Japan,P-135, August 17, 1982, Vol. 6/No. 156 bzw. aus JP-A-570 74 667, dort allerdings für eine Spannungsdetektorschaltung.

Aus der US-A- 4 300 063 ist eine Fenster-Detektorschaltung für eine Airbag-Steuerung bekannt, mittels welcher das Korrekte Verhalten einer den Airbag im Fall einer Umfall-Kollision aktivierenden Zündschaltung überwacht wird. Um festzustellen, ob zwei Signale innerhalb eines vorgegebenen Fensters liegen, werden diese beiden Signale einerseits dem einen Differenzeingang eines in Emitterschaltung betriebenen ersten Differenzverstärkers und dem einen Differenzeingang eines in Basisschaltung betriebenen zweiten Differenzverstärkers zugeführt. Der andere Differenzeingang des ersten Differenzverstärkers ist mit dem anderen Differenzeingang des zweiten Dfferenzverstärkers gekoppelt. Der erste Differenzverstärker reagiert auf das niedrigere der beiden Signale im Verhältnis zu der unteren Referenz- oder Fensterspannung. Der zweite Differenzverstärker reagiert auf das höhere der beiden Signale im Verhältnis zu der oberen Referenz- oder Fensterspannung.

Im folgenden wird die Erfindung anhand einer Ausführungsform näher erläutert.

In den Zeichnungen zeigen:

| | |
|---|---|
| Fig. 1 | einen geschalteten Stromregler der eingangs beschriebenen Art; |
| Fig. 2a bis 2f | Spannungs- und Stromverläufe des in Fig. 1 gezeigten Stromreglers; und |
| Fig. 3 | eine Ausführungsform eines erfindungsgemäßen Komparators oder Operationsverstärkers; |
| Fig. 4 | eine erste Ausführungsform des Stromreglers mit einem erfindungsgemäßen Komparator; und |
| Fig. 5 | eine zweite Ausführungsform des Stromreglers mit einem erfindungsgemäßen Komparator. |

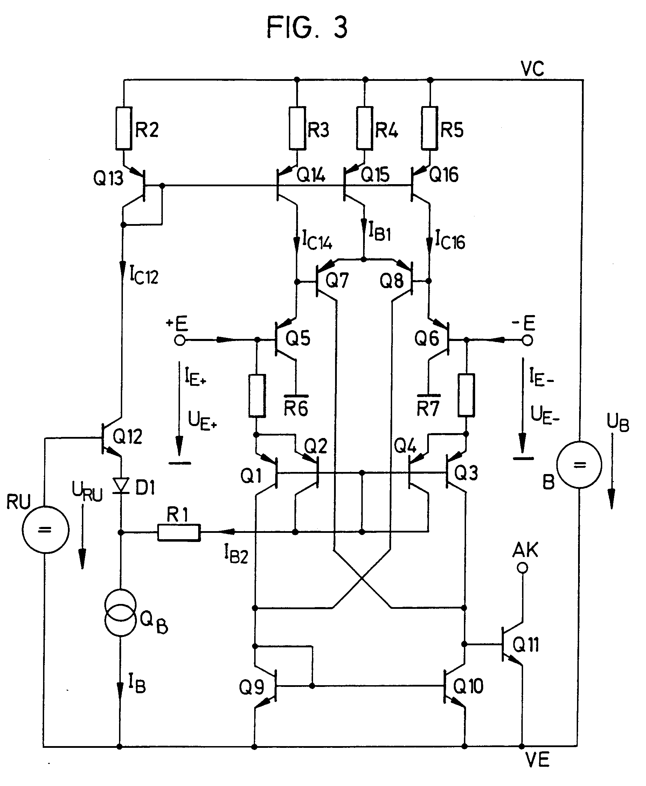

Der in Fig. 3 gezeigte Komparator weist eine erste Eingangs-Differenzstufe mit einem ersten Transistorpaar Q1, Q3 in Basisschaltung auf. Bei Q1 und Q3 handelt es sich um pnp-Transistoren mit einem gemeinsamen Basisanschluß. Die Emitter von Q1 und Q3 sind über Widerstände R6 bzw. R7 an den nicht-invertierenden Komparatoreingang +E bzw. den invertierenden Komparatoreingang -E angeschlossen. In der Praxis wird im allgemeinen nur einer dieser beiden Widerstände zur Kompensation einer Fehlerspannung benötigt, die durch unterschiedliche Quellenwiderstände an den Eingängen entsteht. Der Kollektor von Q1 ist an den Stromeingang und der Kollektor von Q3 ist an den Stromausgang einer Stromspiegelschaltung Q9, Q10 angeschlossen. An den Stromausgang der Stromspiegelschaltung Q9, Q10 ist die Basis eines npn-Transistors Q11 angeschlossen, dessen Kollektor den Ausgangsanschluß AK des Komparators bildet.

An die Emitter der Transistoren Q1 und Q2 sind die Emitter von als Dioden geschalteten pnp-Transistoren Q2 bzw. Q4 angeschlossen, deren Basisanschlüsse und deren Kollektoranschlüsse je an den gemeinsamen Basisanschluß der Transistoren Q1 und Q3 angeschlossen sind. Dieser gemeinsame Basisanschluß ist über einen Widerstand R1 einerseits an das eine Ende einer Konstantstromquelle $Q_B$, die anderen Endes an den Masseanschluß VE angeschlossen ist, und andererseits an die Kathode einer Diode D1 angeschlossen. Letztere befindet sich in Reihenschaltung mit der Kollektor-Emitter-Strecke eines Transistors Q12, dessen Basis über eine Umschaltfrequenzspannungsquelle RU an den Masseanschluß VE angeschlossen ist.

Transistoren Q13, Q14, Q15, Q16 und Widerstände R2, R3, R4, R5 bilden einen Stromspiegel mit einem Stromeingang und drei Stromausgängen. Der Kollektor von Q12 ist an den Stromeingang dieses Stromspiegels angeschlossen.

Eine zweite Eingangs-Differenzstufe weist ein Paar pnp-Transistoren Q7, Q8 in Emitterschaltung auf. Deren gemeinsamer Emitteranschluß ist an den durch Q15 gebildeten Stromausgang des Stromspiegels angeschlossen. Die Kollektoren der Transistoren Q7 und Q8 sind an den Stromausgang bzw. den Stromeingang der Stromspiegelschaltung Q9, Q10 angeschlossen. Die Basis des Transistors Q7 ist einerseits über die Kollektor-Emitter-Strecke eines ersten pnp-Pegelverschiebungs-Emitterfolgers Q5 mit dem Masseanschluß VE und andererseits an den durch Q14 gebildeten Stromausgang des Stromspiegels Q13 - Q16 angeschlossen. Gleichermaßen ist die Basis des Transistors Q8 einerseits über einen zweiten pnp-Pegelverschiebungs-Emitterfolger Q6 mit dem Masseanschluß VE und andererseits an den durch Q16 gebildeten Stromausgang des Stromspiegels Q13 - Q16 angeschlossen. Die Basisanschlüsse der Pegelverschiebungs-Emitterfolger Q5 und Q6 sind mit dem nicht-invertierenden Eingang +E bzw. dem invertierenden Eingang -E verbunden.

Die Zusammenschaltungen der Transistoren Q1, Q2 und Q3, Q4, wobei die diodengeschalteten Transistoren Q2 und Q4 parallel zu den Basis-Emitter-Strecken der Transistoren Q1 bzw. Q3 geschaltet sind, bilden je einen äquivalenten Transistor mit definierter Stromverstärkung.

Mit dieser Schaltung ist es möglich, den Gesamtstrom der Eingangs-Differenzstufe Q1 - Q4 durch den Vorstrom $I_{B2}$ zu bestimmen.

Das Grundprinzip dieser Komparatorschaltung liegt darin, daß die zwei parallel geschalteten Eingangs-Differenzstufen mit den Transistoren Q1 bis Q4 bzw. mit den Transistoren Q5 bis Q8 mit der gleichen Stromspiegelschaltung Q9, Q10 und mit dem als Ausgangsverstärker oder -schalter dienenden Transistor Q11 arbeiten. Dabei wird ein von der Konstantstromquelle $Q_B$ gelieferter Vorstrom $I_B$ mit Hilfe des Transistors Q12 und der Diode D1 in Abhängigkeit von dem Verhältnis zwischen der Eingangsgleichtakt-Spannung und der Umschaltreferenzspannung $U_{RU}$ zu der einen oder der anderen Eingangs-Differenzstufe geleitet. In einem Übernahmebereich der Eingangsgleichtakt-Spannung sind beide Eingangs-Differenzstufen aktiv. In diesem Übernahmebereich teilt sich der Vorstrom $I_B$ in einen Vorstrom $I_{B2}$ für die erste Eingangs-Differenzstufe und einen Vorstrom $I_{C12}$ für die zweite Eingangs-Differenzstufe auf. Mit dem Widerstand R1 kann dieser Übernahmebereich dimensioniert werden.

Unter der Voraussetzung, daß die Eingangs-Differenzspannung

$$U_d = U_{E+} - U_{E-}$$

viel kleiner ist als die Eingangs-Gleichtaktspannung $U_{CM}$, d.h.

$$U_d \ll U_{CM} \qquad (1)$$

ist $U_{E+} \approx U_{CM} \qquad (2)$

und $U_{E-} \approx U_{CM}. \qquad (3)$

Ist

$$U_{CM} < U_{RU} - U_{BE12},$$

wobei $U_{BE12}$ die Basis-Emitter-Spannung des Transistors Q12 ist, sind die diodengeschalteten Transistoren Q2 und Q4 gesperrt, so daß $I_{B2} = 0$ ist. Denn unter Vernachlässigung der Spannungsabfälle über den Widerständen R1 und R6 ergibt sich bei Anwendung der Maschenregel

$$U_{BE2} = U_{CM} - U_{RU} + U_{BE12} + U_{D1}. \qquad (4)$$

Dabei ist $U_{D1}$ die Durchlaßspannung der Diode D1.
Setzt man

$$U_{CM} = U_{RU} - U_{BE12} \qquad (5)$$

dann ist

$$U_{BE2} = U_{D1}. \qquad (6)$$

Für

$$U_{CM} < U_{RU} - U_{BE12} \qquad (7)$$

wird

$$U_{BE2} < U_{D1}. \qquad (8)$$

Da in der Praxis, insbesondere bei integrierten Schaltungen, die Durchlaßspannung einer Diode gleich der Durchlaß-Basis-Emitter-Spannung eines Transistors ist, ist in diesem Fall die über der Basis-Emitter-Diode des Transistors Q2 auftretende Spannung unter der Basis-Emitter-Durchlaß-Spannung, so daß Transistor Q2 sperrt. Unter den Voraussetzungen (1) bis (3) gilt das gleiche für die Transistoren Q1, Q3 und Q4.

Als Folge davon wird der Vorstrom $I_B$ als Kollektorstrom $I_{C12}$ dem Stromspiegel Q13 bis Q16 zugeführt. Mit diesem Stromspiegel werden der Vorstrom $I_{B1}$ der Differenzstufe Q7, Q8 definiert und die Emitterströme der Potentialverschiebungs-Emitterfolger Q5 und Q6 erzeugt.

Unter Anwendung der Maschenregel ergibt sich für den invertierenden Eingangsanschluß -E:

$$U_{CM} + U_{BE6} + U_{BE8} - U_{CE8} - U_{BE9} = 0. \qquad (9)$$

Dabei sind $U_{BE6}$, $U_{BE8}$ und $U_{BE9}$ die Basis-Emitter-Durchlaß-Spannungen der Transistoren Q6 bzw. Q8 bzw. Q9. $U_{CE8}$ ist die Kollektor-Emitter-Spannung des Transistors Q8. Setzt man die Basis-Emitter-Durchlaß-Spannungen aller dieser Transistoren gleich $U_{BE}$, ergibt sich

$$U_{CE8} = U_{CM} + U_{BE}. \qquad (10)$$

Nimmt man für $U_{BE}$ = 0,6 V und für die Sättigungsgrenze ein $U_{CE8}$ = 0,2 V an, kann die Eingangsgleichtakt-Spannung $U_{CM}$ bis auf -0,4 V bezüglich dem Masseanschluß VE absinken, bevor die Transistoren Q7, Q8 in Sättigung gehen würden und die zweite Eingangs-Differenzstufe in den nichtlinearen Bereich gerät.

Im Bereich der Eingangsgleichtaktspannung kleiner als $U_{RU}$ - $U_{BE12}$ ist die Transkonduktanz oder Steilheit des Komparators durch die Steilheit der Differenzstufe Q7, Q8 mit der Stromspiegelschaltung Q9, Q10 und die Stromverstärkung des Transistors Q11 bestimmt. Diese Steilheit ist direkt proportional dem Vorstrom $I_B$ und kann mit dem Stromverhältnis $I_{B1}$ / $I_{C12}$ des Stromspiegels Q15, Q13 beeinflußt werden.

Bei einer Eingangsgleichtaktspannung

$$U_{CM} > U_{RU} - U_{BE12} \qquad (11)$$

werden die Basis-Emitter-Strecken der Transistoren Q1 bis Q4 in Durchlaßrichtung vorgespannt. Daher wird der Strom $I_B$ der Stromquelle $Q_B$ von den leitenden Transistoren Q2, Q4 übernommen. Der Vorstrom $I_{B2}$ der Differenzstufe mit den Transistoren Q1 - Q4 wird dann $I_{B2}$ = $I_B$. Unter Vernachlässigung des Spannungsabfalls an R1 und unter Anwendung der Maschenregel ergibt sich für die Spannung $U_{D1}$ über der Diode D1

$$U_{D1} = U_{RU} - U_{CM} - U_{BE12} + U_{BE2}. \qquad (12)$$

Daraus ergibt sich für den Fall, daß

$$U_{CM} > U_{RU} - U_{BE12} \qquad (13)$$

über der Diode D1 eine Spannung

$$U_{D1} < U_{BE12}. \qquad (14)$$

Das heißt, die Spannung über der Diode wird kleiner als die Basis-Emitter-Durchlaßspannung und somit kleiner als die Dioden-Durchlaßspannung. Als Folge davon sperrt die Diode D1, folglich sperrt auch Transistor Q12, so daß $I_{C12}$ und als Folge davon der Vorstrom $I_{B1}$ des Transistorpaars Q7, Q8 Null wird.

Die Diode D1 sollte eine hohe Sperrspannung aufweisen, um den Emitter-Basis-Durchbruch des Transistors Q12 bei hohen Eingangsgleichtakt-Spannungen zu verhindern.

Im oberen Eingangsgleichtakt-Spannungsbereich größer als $U_{RU}$ - $U_{BE12}$ ist somit die erste Eingangs-Differenzstufe mit den Transistoren Q1 bis Q4 in Betrieb. Die Eingangsgleichtaktspannung bildet dabei die Versorgungsspannung der Eingangs-Differenzstufe mit den Transistoren Q1, Q2 und Q3, Q4 in Basisschaltung. Diese Spannung kann über die Versorgungsspannung $U_B$ am Versorgungsspannungsanschluß VC hinausgehen, da Nichtlinearitäten durch Sättigungseffekte nicht auftreten können.

In diesem oberen Eingangsgleichtakt-Spannungsbereich ist die Transkonduktanz oder Steilheit des Komparators durch die Steilheit der Eingangs-Differenzstufe Q1 bis Q4 mit der Stromspiegelschaltung Q9, Q10 und die Stromverstärkung des Transistors Q11 bestimmt. Diese Steilheit ist ebenfalls dem Strom $I_B$ proportional und kann mit dem Verhältnis der Emitterflächen der Transistoren Q1, Q2 und Q3, Q4 beeinflußt werden.

Verwendet man die erfindungsgemäße Schaltung als linearen Operationsverstärker, kann man die Steilheiten der beiden Eingangs-Differenzstufen durch Wahl des Stromverhältnisses $I_{B1}$ / $I_{C12}$ und/oder durch Wahl des Verhältnisses der Emitterflächen der Transistoren Q1, Q2 und Q3, Q4 einander gleichmachen. Für den Komparatorbetrieb der erfindungsgemäßen Schaltung ist dies nicht erforderlich.

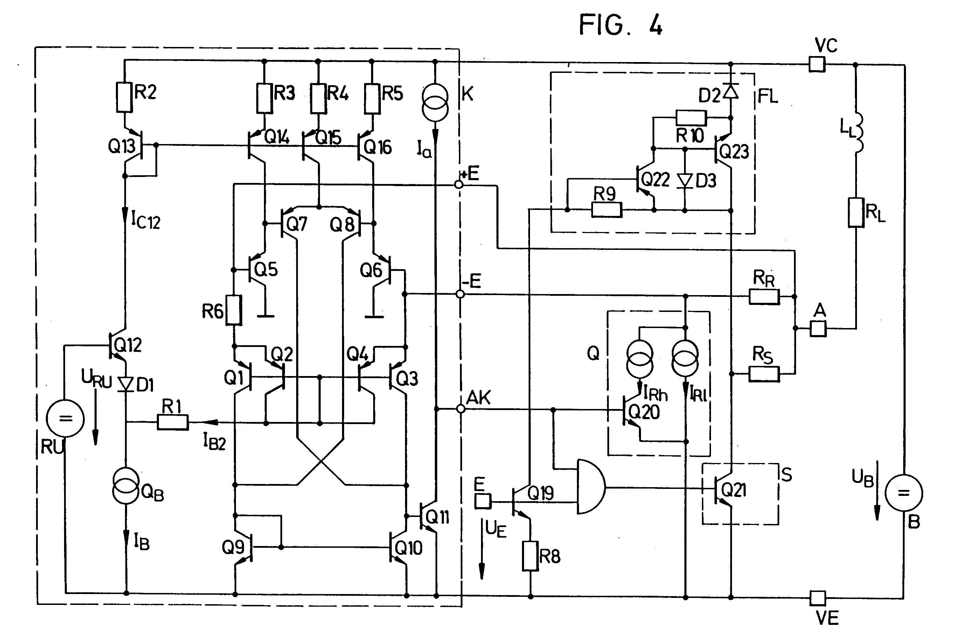

Bei dem in Fig. 4 gezeigten Stromregler wird die an den unterschiedlichen Eingangsquellenwiderständen $R_R$ und $R_S$ durch den Eingangs-Strom erzeugte Fehlerspannung mit dem Spannungsabfall, der sich am Widerstand R6 ergibt, kompensiert.

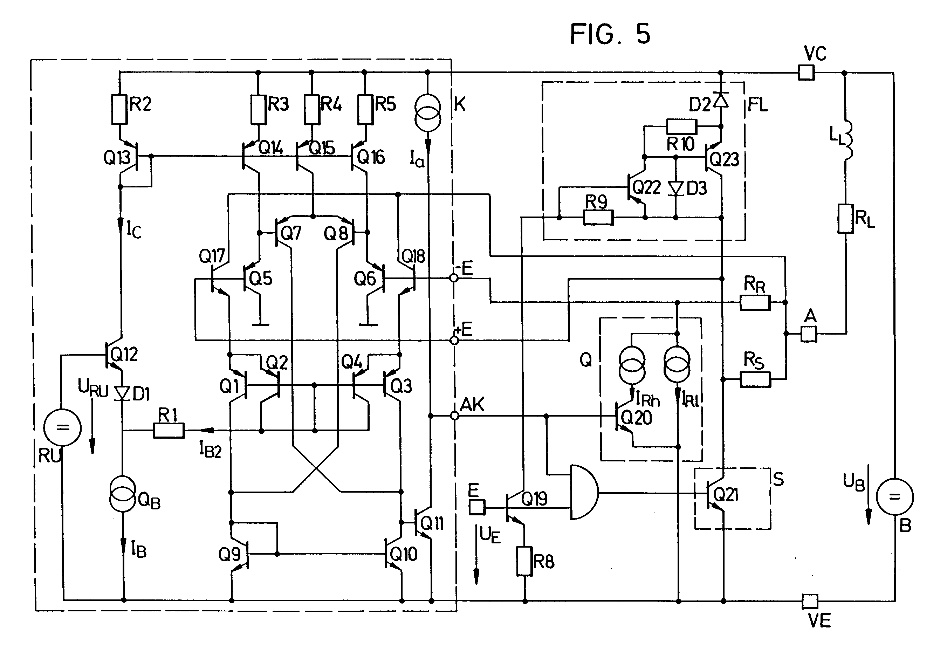

Eine andere Möglichkeit der Reduzierung der Fehlerspannung besteht darin, daß man gemäß Fig. 5 den Eingangs-Strom der in Basisschaltung arbeitenden Eingangs-Differenzstufe durch Vorschalten von zwei Emitterfolgern Q17, Q18 reduziert. Dieses setzt voraus, daß die Kollektoren dieser Emitterfolger Q17, Q18 direkt aus der Signalquelle versorgt werden können.

Mit einem Schaltungsaufbau, der zu dem in Fig. 3 gezeigten komplementär ist, kann man eine Komparatorschaltung mit einem Eingangsgleichtakt-Spannungsbereich realisieren, der von stark negativen Spannungen bezüglich des Masseanschlusses VE bis etwas über die Versorgungsspannung am Versorgungsspannungsanschluß VC reicht. Mit einem solchen Komparator wäre es dann möglich, einen Zweipunkt-Stromregler zu bauen, der Strom in einer induktiven Last mit einem Anschluß an Masse regelt.

**Patentansprüche**

1. Komparator mit einer ersten Eingangsdifferenzstufe ($Q_1$, $Q_3$) und einer dazu parallel geschalteten zweiten Eingangsdifferenzstufe (Q7, Q8), deren Komparatoreingänge (+E, -E) mit eine Eingangsgleichtakt-Spannung aufweisenden Einganasspannungsquellen ($U_{E+}$, $U_{E-}$) verbunden sind, mit einer den beiden Eingangsdifferenzstufen ($Q_1$, $Q_3$, $Q_7$, $Q_8$) gemeinsamen Konstantstromquelle ($Q_B$), deren Strom entweder zu beiden Eingangsdifferenzstufen ($Q_1$, $Q_3$, $Q_7$, $Q_8$) oder nur zu der ersten Eingangsdifferenzstufe ($Q_1$, $Q_3$) oder nur zu der zweiten Eingangs-Differenzstufe ($Q_7$, $Q_8$) gelangt, je nachdem, ob die Eingangsgleichtakt-Spannung des Komparators innerhalb, oberhalb oder unterhalb eines Spannungsbereichs liegt, der sich zwischen den Spannungswerten der beiden Pole einer Versorgungsspannungsquelle (B) des Komparators befindet, und mit einer den Ausgängen beider Eingangs-Differenzstufen nachgeschalteten gemeinsamen ersten Stromspiegelschaltung (Q9, Q10), deren Stromausgang mit einem Ausgangsanschluß (AK) des Komparators gekoppelt ist

dadurch **gekennzeichnet,** daß mindestens eine (Q1, Q3) der beiden Eingangsdifferenzstufen in Basisschaltung angeordnet ist und daß die Emitter dieser Eingangsdifferenzstufe (Q1, Q3) mit den Komparatoreingängen (+E, -E) verbunden sind.

2. Komparator nach Anspruch 1, dadurch **gekennzeichnet,** daß die erste Eingangs-Differenzstufe (Q1, Q3) in Basisschaltung und die zweite Eingangs-Differenzstufe (Q7, Q8) in Emitterschaltung angeordnet ist.

3. Komparator nach Anspruch 2, dadurch **gekennzeichnet,** daß den Differenzeingängen mindestens einer der beiden Eingangs-Differenzstufen ($Q_1$, $Q_3$, $Q_7$, $Q_8$) eine Emitterfolgerstufe (Q5, Q6 bzw. Q17, Q18) voegeschaltet ist.

4. Komparator nach Anspruch 2 oder 3, dadurch **gekennzeichnet,** daß der mit dem invertierenden Komparatoreingang (-E) verbundene Transistor (Q8) des Transistorpaars (Q7, Q8) der zweiten Eingangs-Differenzstufe und der mit dem nicht-invertierenden Komparatoreingang (+E) verbundene Transistor (Q1) des Transistorpaars (Q1, Q3) der ersten Eingangs-Differenzstufe mit einem Stromeingang (Q9) und der mit dem nicht-invertierenden Komparatoreingang (+E) verbundene Transistor (Q7) des Transistorpaars (Q7, Q8) der zweiten Eingangs-Differenzstufe und der mit dem invertierenden Komparatoreingang (-E) verbundene Transistor (Q3) des Transistorpaars (Q1, Q3) der ersten Eingangs-Differenzstufe mit einem Stromausgang (Q10) der Stromspiegelschaltung (Q9, Q10) verbunden sind.

5. Komparator nach mindestens einem der Ansprüche 1 bis 4, dadurch **gekennzeichnet,** daß der Strom ($I_B$) der gemeinsamen Konstantstromquelle ($Q_B$) mittels einer Stromumleitschaltung (Q12, D1, Q2, Q4) zu der jeweils zu betreibenden Eingangs-Differenzstufe geleitet wird, wobei der Stromleitweg von dem Verhältnis der Eingangsgleichtakt-Spannung zu einer Umschaltreferenzspannung ($U_{RU}$) abhängt.

6. Komparator nach Anspruch 5, dadurch **gekennzeichnet,** daß die Stromumleitschaltung (Q12, D1, Q2, Q4) einen mit seiner Kollektor-Emitter-Strecke zu der Stromquelle ($Q_B$) in Reihe geschalteten Umschalttransistor (Q12) aufweist, dessen Basis mit der Umschaltreferenzspannung ($U_{RU}$) vorgespannt ist, dessen Emitter durch die Diode (D1) mit der gemeinsamen Basis der zur ersten Eingangs-Differenzstufe gehörenden Transistoren (Q1 - Q4) und dessen Kollektor mit einer zweiten Stromspiegelschaltung (Q13 - Q16) für die zweite Eingangs-Differenzstufe (Q7, Q8) verbunden ist, so daß der Strom der Stromquelle ($Q_3$) je nach dem Verhältnis zwischen den Werten von Eingangsgleichtakt-Spannung und Umschaltreferenzspannung ($U_{RU}$) entweder zur ersten Eingangsdifferenzstufe (Q1, Q3), der zweiten Eingangsdifferenzstufe (Q7, Q8) mittels der zweiten Stromspiegelschaltung (Q13 - Q16) oder zu beiden gelangt.

7. Komparator nach mindestens einem der Ansprüche 1 bis 6,
dadurch **gekennzeichnet,** daß die erste Eingangsdifferenzstufe (Q1, Q3) ein pnp-Transistorpaar (Q1, Q3) aufweist, deren Emitter mit je einem der beiden Komparatoreingänge ( + E, -E), deren Kollektoren mit dem Stromeingang bzw. dem Stromausgang der ersten Stromspiegelschaltung (Q9, Q10) und deren gemeinsamer Basisanschluß mit der Stromumleitschaltung (Q12, D1, Q2, Q4) verbunden sind.

8. Komparator nach mindestens einem der Ansprüche 2 bis 7,
dadurch **gekennzeichnet,** daß den Emitter-Basis-Strecken der beiden Transistoren (Q1, Q3) des Transistorpaars der ersten Eingangs-Differenzstufe (Q1, Q3) je eine Diode (Q2, Q4) parallelgeschaltet ist, welche die gleiche Polarität wie die Basis-Emitter-Strecke des zugehörigen dieser beiden Transistoren (Q1 bzw. Q3) aufweist.

9. Komparator nach Anspruch 8,
dadurch **gekennzeichnet,** daß die beiden Dioden je durch einen als Diode geschalteten Transistor (Q2, Q4) vom gleichen Leitfähigkeitstyp wie der zugehörige Transistor des Eingangs-Differenzstufen-Transistorpaars (Q1, Q3) gebildet sind.

10. Komparator nach Anspruch 8 oder 9,
dadurch **gekennzeichnet,** daß zwischen den gemeinsamen Basisanschluß der ersten Eingangs-Differenzstufe (Q1, Q3) und den Umschalttransistor (Q12) eine Diode (D1) geschaltet ist.

11. Komparator nach mindestens einem der Ansprüche 7 bis 10,
dadurch **gekennzeichnet,** daß mindestens zwischen den einen Komparatoreingang (-E, + E) und den Emitter des zugehörigen Transistors (Q1 bzw. Q3) der ersten Eingangsdifferenzstufe ($Q_1$, $Q_3$) ein Kompensationswiderstand (R6, R7) geschaltet ist.

12. Komparator nach mindestens einem der Ansprüche 1 bis 11,
dadurch **gekennzeichnet,** daß die zweite Eingangs-Differenzstufe (Q7, Q8) ein pnp-Transistorpaar (Q7, Q8) in Emitterschaltung aufweist.

13. Komparator nach Anspruch 12,
dadurch **gekennzeichnet,** daß die zweite Stromspiegelschaltung (Q13 - Q16) einen mit der Stromumleitschaltung (Q12, D1, Q2, Q4) verbundenen Stromeingang (Q13) und drei Stromausgänge (Q14 - Q16) aufweist, von denen einer (Q15) mit dem gemeinsamen Emitteranschluß des Transistorpaars (Q7, Q8) der zweiten Eingangs-Differenzstufe (Q7, Q8) und die beiden anderen (Q14, Q16) mit dem Emitter je einer der beiden Emitterfolgerstufen (Q5, Q6) verbunden sind.

14. Komparator nach mindestens einem der Ansprüche 1 bis 13,
dadurch **gekennzeichnet,** daß an den Stromausgang (Q10) der ersten Stromspiegelschaltung (Q9, Q10) die Basis eines Ausgangstransistors (Q11) angeschlossen ist, dessen Kollektor den Komparatorausgang (A) bildet.

15. Komparator nach mindestens einem der Ansprüche 1 bis 14 in einem geschalteten Stromregler für eine induktive Last, mit einer zwischen die beiden Pole ($V_C$, $V_E$) einer versorgungsspannungsquelle (B) geschalteten Reihenschaltung mit der induktiven Last (L, $R_L$), einem Stromsensor ($R_S$), dessen Sensorsignal ein Maß für den durch die Induktivität (L) fließenden Strom ($i_L$) ist, und einem steuerbaren Schalter (S), dessen Schaltzustand von dem Ausgangssignal eines Komparators (K) beeinflußt wird, der das Sensorsignal mit einem den Stromsollwert bestimmenden Referenzsignal einer Referenzsignalquelle (SQ, $R_R$) vergleicht und das Umschalten des Schalters (S) jeweils dann bewirkt, wenn das Sensorsignal den Referenzsignalwert erreicht, und mit einem Freilaufkreis mit einer der induktiven Last (L, $R_L$) parallel geschalteten Freilaufeinrichtung (FL), wobei der Stromsensor ($R_S$) im Freilaufkreis angeordnet ist und die Referenzsignalquelle (SQ, $R_R$) in Abhängigkeit von dem Ausgangssignal des Komparators (K) umschaltbar ist zwischen einem hohen Referenzsignalwert, bei dessen Erreichen durch das Sensorsignal der Komparator (K) ein Unterbrechen des zuvor leitenden Schalters (S) bewirkt, und einem niederen Referenzsignalwert, bei dessen Erreichen durch das Sensorsignal der Komparator (K) ein Leitendschalten des zuvor unterbrochenen Schalters (S) bewirkt.

16. Operationsverstärker enthaltend einen Schaltungsaufbau gleich dem des Komparators nach einem oder mehreren der Ansprüche 1 bis 14.

17. Komparator oder Operationsverstärker nach mindestens einem der Ansprüche 1 bis 16 dadurch **gekennzeichnet,** daß der Schaltungsaufbau MOS-Transistoren und/oder JFETs aufweist.

## Claims

1. A comparator comprising a first differential input stage (Q1, Q3) and a second differential input stage (Q7, Q8) connected in parallel thereto, whose comparator inputs (+E, -E) are connected to input voltage sources ($U_{E+}$, $U_{E-}$) having a common-mode input voltage, a constant current source ($Q_B$) which is common to both differential input stages (Q1, Q3, Q7, Q8) and the current of which reaches either both differential input stages (Q1, Q3, Q7, Q8) or only the first differential input stage (Q1, Q3) or only the second differential input stage (Q7, Q8), depending on whether the common-mode input voltage of the comparator is within, above or below a voltage range that is between the voltage values of the two poles of a supply voltage source (B) of the comparator, and comprising a first current mirror circuit (Q9, Q10) which is connected downstream of the outputs of both differential input stages and whose current output is coupled to an output terminal (AK) of the comparator,
**characterized** in that at least one (Q1, Q3) of the two differential input stages is arranged in common-base connection and that the emitters of this differential input stage (Q1, Q3) are connected to the comparator inputs (+E, -E).

2. A comparator according to claim 1,
characterized in that the first differential input stage (Q1, Q3) is arranged in common-base connection and the second differential input stage (Q7, Q8) is arranged in common-emitter connection.

3. A comparator according to claim 2,
characterized in that an emitter follower stage (Q5, Q6 and Q17, Q18, respectively) is connected upstream of the differential inputs of at least one of the two differential input stages (Q1, Q3, Q7, Q8).

4. A comparator according to claim 2 or 3,
characterized in that the transistor (Q8) of the transistor pair (Q7, Q8) of the second differential input stage, which is connected to the inverting comparator input (-E), and the transistor (Q1) of the transistor pair (Q1, Q8) of the first differential input stage, which is connected to the non-inverting comparator input (+E), are connected to a current input (Q9), and the transistor (Q7) of the transistor pair (Q7, Q8) of the second differential input stage, which is connected to the non-inverting comparator input (+E), and the transistor (Q3) of the transistor pair (Q1, Q3) of the first differential input stage, which is connected to the inverting comparator input (-E), are connected to a current output (Q10) of the current mirror circuit (Q9, Q10).

5. A comparator according to at least one of claims 1 to 4,
characterized in that the current ($I_B$) of the common constant current source ($Q_B$) is passed to the particular differential input stage to be operated, by means of a current diversion circuit (Q12, D1, Q2, Q4), the current conduction path being dependent on the ratio of the common-mode input voltage to a switching reference voltage ($U_{RU}$).

6. A comparator according to claim 5,
characterized in that the current diversion circuit (Q12, D1, Q2, Q4) includes a switching transistor (Q12) which has its collector-to-emitter path connected in series with the current source ($Q_B$) and whose base is biased with the switching reference voltage ($U_{RU}$), whose emitter is connected by the diode (D1) to the common base of the transistors (Q1 to Q4) belonging to the first differential input stage and whose collector is connected to a second current mirror circuit (Q13 to Q16) for the second differential input stage (Q7, Q8), so that the current of the current source ($Q_B$), depending on the ratio between the values of the common-mode input voltage and the switching reference voltage ($U_{RU}$), reaches either the first differential input stage (Q1, Q3), the second differential input stage (Q7, Q8) by means of the second current mirror circuit (Q13 to Q16), or both stages.

7. A comparator according to at least one of claims 1 to 6,
characterized in that the first differential input stage (Q1, Q3) comprises a pnp transistor pair (Q1, Q3) whose emitters are each connected to one of the two comparator inputs (+E, -E), whose collectors are connected to the current input and the current output, respectively, of the first current mirror circuit (Q9, Q10), and whose common base terminal is connected to the current diversion circuit (Q12, D1, Q2, Q4).

8. A comparator according to at least one of claims 2 to 7, characterized in that the emitter-to-base paths of the two transistors (Q1, Q3) of the transistor pair of the first differential input stage (Q1, Q3) each have a diode (Q2, Q4) connected in parallel thereto, which has the same polarity as the base-to-emitter path of the associated one of these two transistors (Q1 and Q3, respectively).

9. A comparator according to claim 8, characterized in that the two diodes are each formed by a transistor (Q2, Q4) connected as a diode and having the same conductivity type as the associated transistor of the differential input stage transistor pair (Q1, Q3).

10. A comparator according to claim 8 or 9, characterized in that a diode (D1) is connected between the common base terminal of the first differential input stage (Q1, Q3) and the switching transistor (Q12).

11. A comparator according to at lest one of claims 7 to 10, characterized in that a compensating resistor (R6, R7) is connected at least between the one comparator input (-E, +E) and the emitter of the associated transistor (Q1 and Q3, respectively) of the first differential input stage (Q1, Q3).

12. A comparator according to at least one of claims 1 to 11, characterized in that the second differential amplifier stage (Q7, Q8) comprises a pnp transistor pair (Q7, Q8) in common-emitter connection.

13. A comparator according to claim 12, characterized in that the second current mirror circuit (Q13 to Q16) comprises a current input (Q13), connected to the current diversion circuit (Q12, D1, Q2, Q4), and three current outputs (Q14 to Q16) of which one (Q15) is connected to the common emitter terminal of the transistor pair (Q7, Q8) of the second differential input stage (Q7, Q8) and the other two (Q14, Q16) are connected to the emitter of one of the two emitter follower stages (Q5, Q6) each.

14. A comparator according to at least one of claims 1 to 13, characterized in that the current output (Q10) of the first current mirror circuit (Q9, Q10) has the base of an output transistor (Q11) connected thereto, the collector thereof forming the comparator output (A).

15. A comparator according to at least one of claims 1 to 14 in a switching current regulator for an inductive load, comprising a series connection connected between the two poles ($V_C$, $V_E$) of a supply voltage source (B) and including the inductive load (L, $R_L$), a current sensor ($R_S$) whose sensor signal is a measure for the current ($i_L$) flowing through the inductivity (L), and a controllable switch (S) whose switching condition is influenced by the output signal of a comparator (K) which compares the sensor signal with a reference signal of the reference signal source (SQ, $R_R$) determining the nominal current value and which effects switching over of the switch (S) each time when the sensor signal reaches the reference signal value, and comprising a flyback circuit having a flyback means (FL) connected in parallel to the inductive load (L, $R_L$), the current sensor ($R_S$) being disposed in the flyback circuit and the reference signal source (SQ, $R_R$) being switchable, depending on the output signal of the comparator (K), between a high reference signal value at which, when reached by the sensor signal, the comparator (K) effects interruption of the previously conducting switch (S), and a low reference signal value at which, when reached by the sensor signal, the comparator (K) effects switching into the conducting state of the previously interrupted switch (S).

16. An operational amplifier containing a circuit design equal to that of the comparator according to one or several of the claims 1 to 14.

17. A comparator or operational amplifier according to at least one of claims 1 to 16, characterized in that the circuit design includes MOS transistors and/or JFET's.

**Revendications**

1. Comparateur comprenant un premier étage d'entrée différentiel (Q1, Q3) et un deuxième étage d'entrée différentiel (Q7, Q8) relié en parallèle sur le premier étage, dont les entrées de comparaison (+E, -E) sont reliées à des sources de tension ($U_{E+}$, $U_{E-}$) de mode commun d'entrée, une source de courant constant

($Q_B$) coopérant avec l'un des deux étages différentiels d'entrée (Q1, Q3, Q7, Q8), dont le courant arrive, soit aux deux étages différentiels d'entrée (Q1, Q3, Q7, Q8), soit seulement au premier étage différentiel d'entrée (Q1, Q3) soit seulement au deuxième étage différentiel d'entrée (Q7, Q8), selon que la tension de mode commun d'entrée du comparateur est au-dessus, à l'intérieur, ou en dessous d'une plage de tensions qui se trouve entre les valeurs de tension des deux pôles d'une source de tension d'alimentation (B) du comparateur, et un premier miroir de courant (Q9, Q10) relié en aval de l'une des sorties des deux étages différentiels d'entrée, caractérisé en ce que

au moins l'un des deux étages différentiels d'entrée (Q1, Q3) est connecté en amplificateur à base commune et en ce que les émetteurs de cet étage différentiel d'entrée (Q1, Q3) sont reliés aux entrées de comparaison (+ E, -E).

2. Comparateur selon la revendication 1, caractérisé en ce que le premier étage différentiel d'entrée (Q1, Q3) est connecté en amplificateur à base commune et le deuxième étage différentiel d'entrée (Q7, Q8) est connecté en amplificateur à émetteur commun.

3. Comparateur selon la revendication 2, caractérisé en ce que les entrées différentielles d'au moins un des deux étages différentiels d'entrée (Q1, Q3, Q7, Q8) est précédé d'un étage suiveur (Q5, Q6 ; Q17, Q18).

4. Comparateur selon la revendication 2 ou 3, caractérisé en ce que le deuxième étage différentiel d'entrée comprend une paire de transistors (Q7, Q8) dont celui (Q8) qui est relié à l'entrée inverseuse (-E) du comparateur est relié à une entrée de courant (Q9), en ce que le premier étage différentiel d'entrée comprend une paire de transistors (Q1, Q3) dont celui (Q1) qui est relié à l'entrée non-inverseuse (+ E) du comparateur, est relié à ladite entrée de courant (Q9), en ce que le transistor (Q7) de la paire de transistors (Q7, Q8) du deuxième étage différentiel d'entrée qui est relié à l'entrée non-inverseuse (+ E) du comparateur est relié à une sortie (Q10) du miroir de courant (Q9, Q10), et en ce que le transistor (Q3) de la paire de transistors (Q1, Q3) du premier étage différentiel d'entrée, qui est relié à l'entrée inverseuse (-E) du comparateur, est relié à ladite sortie de courant (Q10).

5. Comparateur selon l'une quelconque des revendications 1 à 4, caractérisé en ce que le courant ($I_B$) de la source de courant constant ($Q_B$) est amené à l'étage différentiel d'entrée à commander par un circuit de dérivation de courant (Q12, D1, Q2, Q4), d'où il résulte que le chemin du courant dépend du rapport de la tension de mode commun d'entrée et d'une tension de référence de commutation ($U_{RU}$).

6. Comparateur selon la revendication 5, caractérisé en ce que le circuit de dérivation de courant (Q12, D1, Q2, Q4) comprend un transistor de commutation (Q12) relié en série avec la source de courant ($Q_B$), dont la base est polarisée par la tension de référence de commutation ($U_{RU}$), dont l'émetteur est relié par la diode (D1) aux bases des transistors (Q1-Q4) appartenant au premier étage différentiel d'entrée et dont le collecteur est relié à un deuxième miroir de courant (Q13-Q16) pour le deuxième étage différentiel d'entrée (Q7, Q8), de manière que le courant de la source de courant ($Q_B$) arrive, selon le rapport entre les valeurs de la tension de mode commun d'entrée et de la tension de référence de commutation ($U_{RU}$), soit au premier étage différentiel d'entrée (Q1, Q3), soit au deuxième étage différentiel d'entrée (Q7, Q8) par l'intermédiaire du deuxième miroir de courant (Q13-Q16), soit aux deux étages.

7. Comparateur selon l'une quelconque des revendications 1 à 6, caractérisé en ce que le premier étage différentiel d'entrée (Q1, Q3) comprend une paire de transistors PNP (Q1, Q3), dont les émetteurs sont reliés respectivement aux entrées de comparaison (+ E, -E), dont les collecteurs sont reliés respectivement aux entrée et sortie de courant du premier miroir de courant (Q9, Q10) et dont les bases sont reliées au circuit de dérivation de courant (Q12, D1, Q2, Q4).

8. Comparateur selon l'une quelconque des revendications 2 à 7, caractérisé en ce que les deux transistors (Q1, Q3) de la paire de transistors du premier étage différentiel d'entrée (Q1, Q3) sont reliés en parallèle sur des diodes (Q2, Q4) respectives qui sont connectées dans le même sens que les jonctions base-émetteur des transistors correspondants (Q1, Q3).

9. Comparateur selon la revendication 8, caractérisé en ce que les deux diodes respectives sont constituées chacune par un transistor (Q2, Q4) connecté en diode de même type que le transistor correspondant de la paire de transistors de l'étage différentiel d'entrée (Q1, Q3).

10. Comparateur selon la revendication 8 ou 9, caractérisé en ce qu'une diode (D1) est connectée entre les bases communes du premier étage différentiel d'entrée (Q1, Q3) et le transistor de commutation (Q12).

11. Comparateur selon l'une quelconque des revendications 7 à 10, caractérisé en ce qu'une résistance de compensation (R6, R7) est connectée au moins entre une entrée de comparaison (-E, + E) et l'émetteur du transistor correspondant (Q1, Q3) du premier étage différentiel d'entrée.

12. Comparateur selon l'une quelconque des revendications 1 à 11, caractérisé en ce que le deuxième étage différentiel d'entrée (Q7, Q8) comprend une paire de transistors PNP (Q7, Q8) connectés en amplificateur à émetteur commun.

13. Comparateur selon la revendication 12, caractérisé en ce que le deuxième miroir de courant (Q13-Q16) comprend une entrée (Q13) reliée au circuit de dérivation de courant (Q12, D1, D2, Q4) et trois sorties de courant (Q14-Q16) dont l'une (Q15) est reliée aux émetteurs communs de la paire de transistors (Q7, Q8) du deuxième étage différentiel d'entrée (Q7, Q8) et les deux autres (Q14, Q16) aux émetteurs des deux étages suiveurs (Q5, Q6), respectivement.

14. Comparateur selon l'une quelconque des revendications 1 à 13, caractérisé en ce que la base d'un transistor de sortie (Q11) est reliée à la sortie de courant (Q10) du premier miroir de courant (Q9, Q10), le collecteur de ce transistor de sortie constituant la sortie (A) du comparateur.

15. Comparateur selon l'une quelconque des revendications 1 à 14, inclus dans un régulateur de courant à découpage pour une charge inductive, comprenant une connexion en série entre les deux pôles ($V_C$, $V_E$) d'une source de tension d'alimentation (B), cette connexion en série comprenant la charge inductive (L, $R_L$), un capteur de courant ($R_S$) dont le signal représente une mesure du courant ($i_L$) circulant dans l'inductance (L), et un commutateur commandé (S) dont l'état de commutation est déterminé par le signal de sortie d'un comparateur (K) qui compare le signal du capteur à un signal de référence déterminant une valeur seuil de courant, fourni par une source de signal de référence (SQ, $R_R$) et qui entraîne la commutation du commutateur (S) quand le signal du capteur atteint la valeur du signal de référence, et un circuit de roue libre comprenant un dispositif de roue libre (FL) connecté en parallèle sur la charge inductive (L, $R_L$), le capteur de courant ($R_S$) étant disposé dans le circuit de roue libre et la source de signal de référence (SQ, $R_R$) étant commutable en fonction du signal de sortie du comparateur (K) entre une valeur élevée de signal de référence qui entraîne, lorsqu'elle est atteinte par le signal du capteur, une commutation par le comparateur (K) à l'état bloqué du commutateur (S) précédemment conducteur, et une valeur de signal de référence basse qui entraîne, lorsqu'elle est atteinte par le signal du capteur, une commutation à l'état conducteur par le comparateur (K) du commutateur (S) précédemment bloqué.

16. Amplificateur opérationnel comprenant un circuit identique à celui du comparateur selon l'une ou plusieurs des revendications 1 à 14.

17. Comparateur ou amplificateur opérationnel selon l'une quelconque des revendications 1 à 16, caractérisé en ce que le circuit comprend des transistors MOS et/ou des transistors à effet de champ à jonction.

# FIG. 1

FIG. 2

(a) $u_E$

(b) $i_R$

(c) $u_S$

(d) $u_d$

(e) $i_L$     $I_H$    $I_L$

(f) $u_A$    $U_{FLD}$    $U_{FLZD}$

EP 0 288 016 B1

# FIG. 3

# FIG. 4

EP 0 288 016 B1

FIG. 5

EP 0 288 016 B1